# EUROPEAN PATENT APPLICATION

(11) **EP 1 852 918 A2**
(43) Date of publication of application: **07.11.2007**
(21) Application number: 07009085.7
(22) Date of filing: 04.05.2007
(51) Int. Cl.: H01L 31/052, H01L 31/0224, H01L 31/0203

(54) **Solar concentrating photovoltaic device with resilient cell package assembly**

(30) Priority: 05.05.2006 US 382004
(71) Applicant: SolFocus, Inc., Palo Alto CA 94034 (US); Palo Alto Research Center Incorporated, Palo Alto, California 94304 (US)
(72) Inventor: Fork, David K., Los Altos CA 94024 (US); Duff, David G., Woodside CA 94062 (US); Weisberg, Michael C., Woodside CA 94062 (US); Zimmermann, Thomas S., 07745 Jena (DE); Horne, Stephen J., El Granada CA 94018 (US)
(74) Representative: Epping - Hermann - Fischer

(57) **Abstract**

A Cassegrain-type concentrating solar collector cell includes primary and secondary mirrors disposed on opposing convex and concave surfaces of a light-transparent (e.g., glass) optical element. Light enters an aperture surface surrounding the secondary mirror, and is reflected by the primary mirror and the secondary mirror onto a photovoltaic cell, which is disposed in a central cavity formed in the optical element.
A resilient, optically transmissive material is disposed in the central cavity between the PV cell and the optical element. The photovoltaic cell has a squarish upper surface including metal electrical contact structures disposed on each of the four corners of the upper surface and arranged to define a circular active area. The PV cell is mounted on a heat slug that is disposed in the central cavity during assembly. The heat slug includes resilient fingers that contact the surface of the cavity to facilitate self-alignment of the PV cell.

## Description

This invention relates to solar power generators, more particularly to concentrating-type photovoltaic devices.

Photovoltaic solar energy collection devices used to generate electric power generally include flat-panel collectors and concentrating solar collectors. Flat collectors generally include PV cell arrays and associated electronics formed on semiconductor (e.g., monocrystalline silicon or polycrystalline silicon) substrates, and the electrical energy output from flat collectors is a direct function of the area of the array, thereby requiring large, expensive semiconductor substrates. Concentrating solar collectors reduce the need for large semiconductor substrates by concentrating light beams (i.e., sun rays) using, e.g., a parabolic reflectors or lenses that focus the beams, creating a more intense beam of solar energy that is directed onto a small PV cell. Thus, concentrating solar collectors have an advantage over flat-panel collectors in that they utilize substantially smaller amounts of semiconductor. Another advantage that concentrating solar collectors have over flat-panel collectors is that they are more efficient at generating electrical energy.

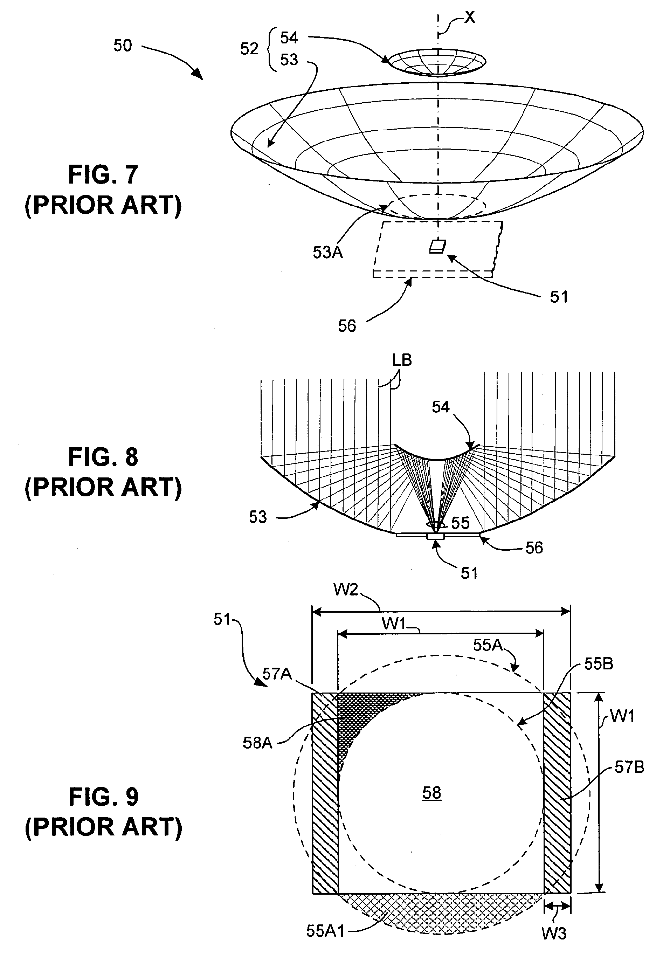

Figs. 7 and 8 are exploded perspective view and cross-sectional side views showing a simplified conventional Cassegrain-type concentrating solar collector 50 that includes a PV cell 51 and a solar concentrator optical system 52 including a primary mirror 53 and a secondary mirror 54 that reflect and focus light beams LB through a central opening 53A of primary mirror 53 to form a focused beam 55 (i.e., a region of peak irradiance or power per unit area). Primary mirror 53 and secondary mirror 54 are supported on a frame (not shown), and PV cell 51 is mounted on a structural support or stage 56 that maintains PV cell 51 in the image plane of solar concentrator optical system 52 such that PV cell 51 coincides with focused beam 55.

A problem with conventional concentrating solar collectors, such as solar collector 50, is that they are expensive to operate and maintain. The solar collector optics (e.g., primary mirror 53 and secondary mirror 54) used in conventional collectors to focus the light beams are produced separately, and must be painstakingly assembled to provide the proper alignment between focused beam 55 and PV cell 51 (i.e., such that focused beam 55 is centered on PV cell 51). Further, over time, the reflectors and/or lenses can become misaligned due to thermal cycling or vibration, causing focused beam to become misaligned, and become dirty due to exposure to the environment, thus reducing the intensity of focused beam 55. Maintenance in the form of cleaning and adjusting the reflectors/lenses can be significant, particularly when the reflectors/lenses are produced with uneven shapes that are difficult to clean.

Fig. 9 is plan view showing the upper surface of a conventional PV cell 51. When generated by standardized integrated circuit fabrication techniques, PV cell 51 includes a square or rectangular semiconductor "chip" that is processed to convert light into an electrical current that flows between base conductors (not shown) formed on a lower surface of the "chip", and a pair of upper emitter conductors 57A and 57B that are disposed on the upper surface of the "chip" and extend along opposing side edges of active area 57. Disposed between conductors 57A and 57B is an exposed, square-shaped central "active" area 58. Because the side regions of PV cell 51 that are covered by metal contact structures 57A and 57B do not receive solar light, the total light receiving area of PV cell 51 is defined by square-shaped active area 58, which in the disclosed embodiment has an area W1². However, due to metal contact structures 57A and 57B, the total width W2 of the upper surface of conventional PV cell 51 is the sum of width W1 and the widths W3 of the two metal contact structures 57A and 5B. In one embodiment, the width W1 is 1 mm, and the width W3 is 0.1 mm, thus providing a total width W1 of 1.2mm, and a total area of 1.2mm².

Because PV cell 51 accounts for a significant portion of the overall cost of concentrating solar collector 50, there is a significant incentive to minimize the size (and, hence, the production cost) of PV cell 51. In this regard, a problem with conventional PV cell 51 is the inefficient conversion of circular solar light (e.g., focused beam 55; see Fig. 8) by square-shaped active area 58. That is, the power generated by conventional PV cell 51 is generally related to the total amount of the incident light applied to active area 58-higher intensity beams generate greater power than lower intensity beams, and illuminating a large portion of the active area produces more power than when only a small portion of the active area is illuminated. Unfortunately, the circular focused beam generated by the optical system (i.e., an image of the sun) does not match the square-shaped active area 58, and therefore either a portion of the incident light must be directed off of the active area, or portions of the active area must remain unilluminated. For example, as indicated in Fig. 9), when the solar concentrator optics of a concentrating solar collector generate a relatively large, low intensity focused beam 55A that illuminates the entire active area 58, portions of focused beam 55A (e.g., indicated by shaded region 55Al) fall outside of active area 58, thus preventing conversion of portions 55A1 from being converted to power. Conversely, when the solar concentrator optics of a conventional concentrating solar collector generate a relatively small, high intensity focused beam 55B that is entirely disposed on active area 58, corner portions of active area 58 (e.g., indicated by shaded region 58A1) remain inactive (unilluminated), thus wasting these portions of PV cell 51.

What is needed is a concentrator PV (CPV) device that avoids the expensive assembly and maintenance costs associated with conventional concentrator-type PV cells, provides a compliant and optically stable package for the PV cell, and more efficient use of the active area of the PV cell.

This object is achieved according to the invention by means of a CPV device according to claim 1. Claim 9 specifies a method for producing a CPV device according to the invention. Advantageous refinements of the invention are specified in the dependent claims.

In an embodiment of the present invention a Cassegrain-type CPV device utilizes a solid glass or plastic optical structure having a convex (protruding) lower surface, a central cavity defined in the lower surface, and an upper aperture surface having a centrally-located concave (curved) surface (e.g., a depression). The convex surface is preferably relatively large and the concave curved surface relatively small, i.e. the convex surface is larger than the concave surface. Cassegrain-type primary and secondary mirrors are respectively disposed on the convex lower surface and in the central depression such that the reflective surfaces face into the optical structure. A lower cover includes a central portion disposed over the central cavity, and one or more peripheral portions extending from the central portion over the backside surface of the primary mirror. A PV cell is mounted on the central portion of the lower cover such that the PV cell is disposed inside the central cavity. In one embodiment, the convex and concave surfaces are associated conic (e.g., hyperbolic and/or parabolic) surfaces arranged such that the portion of light passing through the aperture surface onto any point on the primary mirror is reflected to a corresponding point on the secondary mirror, which in turn re-reflects the light, and focuses the light into the central cavity and onto the PV cell. Because the optical structure is solid (i.e., because the convex and concave surfaces remain fixed relative to each other), the primary and secondary mirrors remain permanently aligned, thus maintaining optimal optical operation while minimizing maintenance costs. Moreover, the loss of light at gas/solid interfaces is minimized because only solid optical material (e.g., low-iron glass) is positioned between the primary and secondary mirrors.

In accordance with an aspect of the present invention, the space inside the central cavity between the molded optical element and the PV cell is filled with a resilient, optically transmissive material suitable for withstanding the intense light at and in proximity to the cell. The resilient, optically transmissive material precludes open cavities that can scatter light, disrupt thermal conduction, and become points of failure over time. In one embodiment, the resilient, optically transmissive material is a gel that assumes a liquid state when uncured, and a relatively solid state when subsequently cured. An advantage to using a curable gel material is that it can be introduced into the cavity in an uncured liquid state, which allows the gel material to fill the complex shapes surrounding the PV cell. A further advantage of using such a gel material is that mechanical movement of the parts (e.g., the PV cell and its supporting structure) during assembly and operation can be accommodated without the formation of cracks or voids in the critical cell joint region. Preferably, the gel material is silicone because such materials are mechanically compliant, are known to be optically stable over temperature and humidity, and are capable of withstanding extended exposure to ultraviolet radiation without yellowing. In accordance with another aspect, the gel material is light transmissive at least down to the longest wavelength (lowest photon energy) converted by the PV cell. This longest wavelength is determined by the smallest band gap in the cell, which may be a multi-junction cell.

In accordance with another aspect of the present invention, a PV cell of the CPV device includes contact structures disposed on the four corners of the upper (exposed) surface, whereby the contact structures define a central, substantially circular active area. Because the focused beam generated by a Cassegrain-type optical system is circular, the PV cell of the present invention provides efficient use of the PV cell active area, thus reducing production costs by minimizing the overall "chip" size of the PV cell.

In accordance with a further aspect of the present invention, the metallization pattern includes gridlines in a radial and azimuthal pattern. Because the light forms a circular spot centered on the cell, the photo-generated current will increase radially from the center to the edge of the cell. Gridlines that extend radially inward from the corners of the cell toward the center are optimally suited to the current generation of the cell. Optional azimuthal extensions on the radial gridlines may be added to further reduce the distance carriers need to migrate within the semiconductor before reaching a gridline. Further optimization of the precise spacing and number of gridlines as well as their dimensions is dependent on the efficiency of the cell and the level of concentrated light reaching the cell and is routinely undertaken by those skilled in the art of gridline optimization.

In accordance with another aspect of the present invention, the PV cell is mounted onto a heat slug that is then mounted into the cavity formed in the optical element. Given that the optical element is preferably made of glass, and the heat slug is preferably made of metal, it is expected that the two objects will have different coefficients of thermal expansion. Therefore, it is desirable for the photovoltaic cell and the heat slug to form an assembly that self-centers itself into the central cavity. Accordingly, in one embodiment, the heat slug includes several resilient fingers that facilitate self-alignment of the heat slug in the cavity, thereby self-aligning the PV cell with the focal point of the optical system associated with the optical element. The PV cell is mounted onto the backside surface of the heat slug, which defines a circular opening positioned over the circular active area of the PV cell. The emitter (topside) contacts of the PV cell are electrically connected (e.g., soldered) to the heat slug, which provides a conductive path between the PV cell and a first external conductor. The base (bottom side) contact of the PV cell is electrically connected to a second conductor. In one embodiment, the first and second conductors are provided on the lower cover that is conformally mounted onto a backside surface of the optical element.

These and other features, aspects and advantages of the present invention will become better understood with regard to the following description, appended claims, and accompanying drawings, where:
Fig. 1 is an exploded perspective view showing a CPV device according to an embodiment of the present invention;
Fig. 2 is a cross-sectional side view showing the CPV device of Fig. 1 during operation;
Fig. 3 is a perspective view showing a PV cell for a CPV device according to another embodiment of the present invention;
Fig. 4 is an exploded perspective view showing a CPV device according to a specific embodiment of the present invention;
Fig. 5 is a partial cross-sectional perspective view showing a heat slug of the CPV device of Fig. 3 in additional detail;
Fig. 6 is simplified partial cross-sectional side view showing the CPV of Fig. 4 in additional detail;
Fig. 7 is a perspective view showing a conventional concentrating-type solar photovoltaic device;
Fig. 8 is a cross-sectional side view showing the conventional device of Fig. 7 during operation; and
Fig. 9 is a plan view showing a conventional PV cell utilized in the conventional device of Fig. 7.

The present invention relates to a concentrator PV (CPV) device that avoids the expensive assembly and maintenance costs associated with conventional concentrator-type PV cells, provides a compliant and optically stable package for the PV cell, and more efficient use of the active area of the PV cell. In particular, the present invention provides structures and methods that improve the attachment and performance of PV cells in solid dielectric solar concentrators, such as that disclosed in co-owned and co-pending U.S. Patent Application Serial Number 11/110,611 entitled "CONCENTRATING SOLAR COLLECTOR WITH SOLID OPTICAL ELEMENT", which is incorporated herein by reference in its entirety.

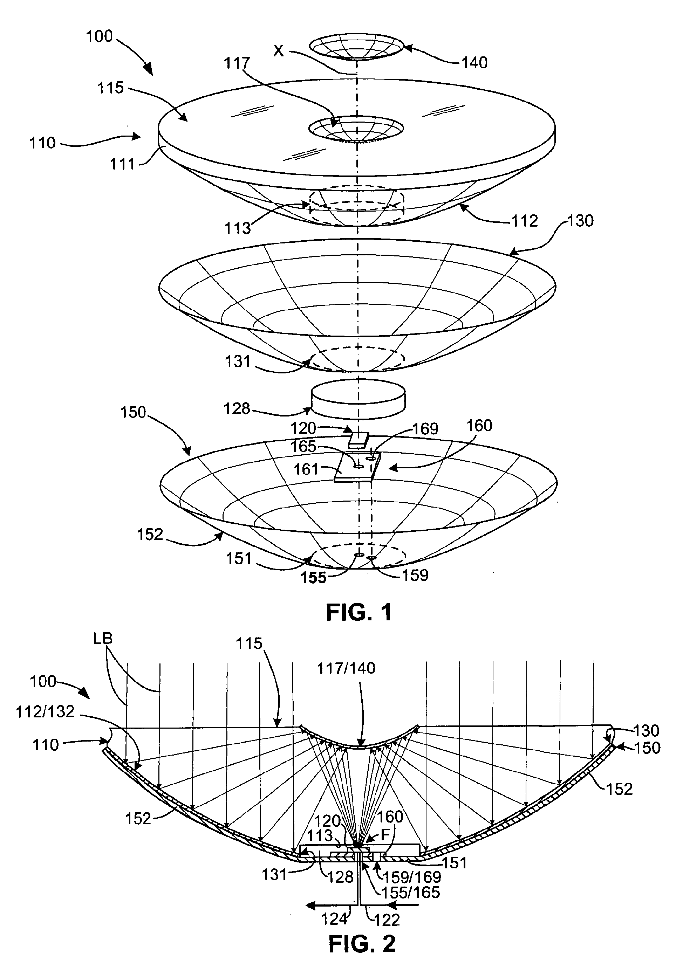

Fig. 1 is an exploded perspective view showing an internal mirror, Cassegrain-type concentrator photovoltaic (CPV) device 100 according to a simplified embodiment of the present invention. Concentrating solar collector 100 generally includes an optical element 110, a photovoltaic (PV) cell 120, a primary mirror 130, a secondary mirror 140, and an optional lower cover 150.

Optical element 110 is a solid, disk-like, light-transparent structure including an upper layer 111, a relatively large convex surface 112 protruding from a lower side of upper layer 111, a substantially flat aperture surface 115 disposed on an upper side of upper layer 111, and a relatively small concave (curved) surface (depression) 117 defined in aperture surface 115 (i.e., extending into upper layer 111). In order to minimize material, weight, thickness and optical adsorption, upper layer 111 may be vanishingly small. In one embodiment, optical element 110 is molded using a low-iron glass (e.g., Optiwhite glass produced by Pilkington PLC, UK) structure according to known glass molding methods. Alternatively, clear plastic may be machined and polished to form single-piece optical element 110, or separate pieces by be glued or otherwise secured to form optical element 110.
In a preferred embodiment, optical element 110 is 5 to 12 mm thick and 20 to 40 mm wide. This thickness helps to ensure that the heat conduction path from the backside convex surface 112 to aperture surface 115 does not become too resistive as it would be if optical element 110 were either thicker or hollow.

PV cell 120 is located in a central cavity region 113 that is defined in the center of convex surface 112. PV cell 120 is connected by way of suitable conductors 122 and 124 (indicated in Fig. 2), for example, to the PV cells of adjacent CPV devices (not shown) using known techniques. Suitable photovoltaic (concentrator solar) cells are produced, for example, by Spectrolab, Inc. of Sylmar, California, USA.

Primary mirror 130 and secondary mirror 140 are respectively disposed on convex surface 112 and concave surface 117. Primary mirror 130 and secondary mirror 140 are shaped and arranged such that, as shown in Fig. 2, light beams LB traveling in a predetermined direction (e.g., perpendicular to aperture surface 115) that enter optical element 110 through a specific region of aperture surface 115 are reflected by a corresponding region of primary mirror 130 to an associated region of secondary mirror 140, and from the associated region of secondary mirror 140 to PV cell 120 (e.g., directly from secondary mirror 140 to PV cell 120, or by way of a reflective or refractive surface positioned between secondary mirror and PV cell 120). As used herein, directional terms such as "upper", "lower", "above" and "below" are intended to provide relative positions for purposes of description, and are not intended to designate an absolute frame of reference. In one embodiment, primary mirror 130 and secondary mirror 140 are fabricated by sputtering or otherwise depositing a reflective mirror material (e.g., silver (Ag) or aluminum (Al)) directly onto convex surface 112 and concave surface 117, thereby minimizing manufacturing costs and providing superior optical characteristics. By sputtering or otherwise forming a mirror film on convex surface 112 and concave surface 117 using a known mirror fabrication technique, primary mirror 130 substantially takes the shape of convex surface 112, and secondary mirror 140 substantially takes the shape of concave surface 117. As such, optical element 110 is molded or otherwise fabricated such that convex surface 112 and concave surface 117 are arranged and shaped to produce the desired mirror shapes. Note that, by forming convex surface 112 and concave surface 117 with the desired mirror shape and position, primary mirror 130 and secondary mirror 140 are effectively self-forming and self-aligning, thus eliminating expensive assembly and alignment costs associated with conventional concentrating solar collectors. Further, because primary mirror 130 and secondary mirror 140 remain affixed to optical element 110, their relative position is permanently set, thereby eliminating the need for adjustment or realignment that may be needed in conventional multiple-part arrangements. In one embodiment, primary mirror 130 and secondary mirror 140 are formed simultaneously using the same (identical) material or materials (e.g., plated Ag), thereby minimizing fabrication costs. Further, by utilizing the surfaces of optical element 110 to fabricate the mirrors, once light enters into optical element 110 through aperture surface 115, the light is only reflected by primary mirror 130/convex surface 112 and secondary mirror 140/concave surface 117 before reaching PV cell 120. As such, the light is subjected to only one air/glass interface (i.e., aperture surface 115), thereby minimizing losses that are otherwise experienced by conventional multi-part concentrating solar collectors. The single air/glass interface loss can be further lowered using an antireflection coating on aperture surface 115. Although it is also possible to separately form primary mirror 130 and secondary mirror 140 and then attach the mirrors to convex surface 112 and concave surface 117, respectively, this production method would greatly increase manufacturing costs and may reduce the superior optical characteristics provided by forming mirror films directly onto convex surface 112 and concave surface 117.

Lower cover 150 includes a central portion 151 and a curved peripheral portion 152 extending outward from central portion 151. In one embodiment, lower cover 150 includes a material having relatively high thermal conductivity, and includes a thickness selected such that a lateral thermal resistance of lower cover 150 (i.e., measured in a radial direction from central portion 151 to the outer edge of peripheral portions 152) is less than a transverse thermal resistance of optical element 110 (i.e., measured from the convex surface 112 to the aperture surface 115), as described in co-owned U.S. Patent Application No. 11/381,999, entitled "PASSIVELY COOLED SOLAR CONCENTRATING PHOTOVOLTAIC DEVICE" [Atty Docket No. 20060255/XCP-069], which is filed on the same date as the present application and is incorporated herewith by reference in its entirety. In another embodiment, lower cover 150 includes a protective layer (e.g., Tedlar®, which is a trademark of the DuPont Corporation, or TPT (Tedlar, polyester, Tedlar), which is a three-ply material engineered for strength, stability and dielectric breakdown strength) that is disposed over cavity 113, and is secured to the back (non-reflecting) surface of primary mirror 130 using a suitable adhesive (e.g., Ethylene vinyl acetate copolymers (EVA)). PV cell 120 is mounted on an inside surface of central portion 151 such that PV cell 120 is disposed inside cavity 113. Lower cover 150 is laminated onto optical element 110, for example, using lamination techniques disclosed in co-owned and co-pending U.S. Patent Application Serial Number 11/382,008, entitled "LAMINATED SOLAR CONCENTRATING PHOTOVOLTAIC DEVICE" [Atty Dkt No. 20060351-US-NP (XCP-071)], which is co-filed with the present application and incorporated herewith by reference in its entirety.

Fig. 2 is a side view showing concentrating solar collector 100 during operation. Similar to conventional concentrating solar collectors, a collector positioning system (not shown; for example, the tracking system used in the MegaModuleTM system produced by Amonix, Incorporated of Torrance, California, USA) is utilized to position concentrating solar collector 100 such that light beams LB (e.g., solar rays) are directed into aperture surface 115 in a desired direction (e.g., perpendicular to aperture surface 115. PV cell 120 is disposed substantially in a concentrating region F, which designates the region at which light beams LB are concentrated by primary mirror 130, secondary mirror 140 and any intervening optical structures (e.g., a dielectric flux concentrator). To facilitate the positioning of concentrating region F in central cavity 113, convex surface 112, primary mirror 130, concave surface 117, and secondary mirror 140 are centered on and substantially symmetrical about an optical axis X that extends substantially perpendicular to aperture surface 115 (i.e., the curved portions of convex surface 112 and concave surface 117 are defined by an arc rotated around optical axis X).

Referring again to Fig. 1, in accordance with an aspect of the present invention, a resilient optically transmissive material 128 is disposed inside cavity 113 over PV cell 120 (i.e., between PV cell 120 and the surface of optical element 110 located inside cavity 113). In one embodiment, optically transmissive material 128 includes silicone (e.g., polydiphenylsiloxane or polymethylphenylsiloxane), which is suitable for withstanding the intense light at and in proximity to PV cell 120. Optically transmissive material 128 is disposed in cavity 113 such that it precludes voids or openings (e.g., air pockets) that can scatter light, disrupt thermal conduction, and become points of failure over time.

In one embodiment, the gel material (e.g., silicone) utilized for optically transmissive material 128 is in a gel form that has a liquid state when uncured, and a relatively solid state when subsequently cured. A suitable curable silicone gel is produced by Dow Corning under the model name/number Sylgard 3- 6636. An advantage to using such a curable gel material is that it can be introduced into cavity 113 in an uncured liquid state, which allows the gel material to fill the complex shapes surrounding PV cell 120. A further advantage of using such a gel material is that mechanical movement of the parts (e.g., the PV cell and its supporting structure) during assembly and operation can be accommodated without the formation of cracks or voids in the critical cell joint region. Another advantage to using silicone for the gel material is that is mechanically compliant, are known to be optically stable over temperature ranges (e.g., below 100°C) and humidity ranges typically experienced by CPV devices, and are capable of withstanding extended exposure to ultraviolet radiation without yellowing. In accordance with another aspect, the gel material is light transmissive at least down to the longest wavelength (lowest photon energy) converted by PV cell 120. This longest wavelength is determined by the smallest band gap in PV cell 120, which may be a multi-junction cell.

In accordance with another embodiment of the present invention, a method for producing CPV device 100 includes mounting PV cell 120 a heat slug 160 that is then mounted into central cavity 113 of optical element 110. Heat slug 160 includes a metal substrate 161 that is in thermal contact with PV cell 120, and serves to transfer heat from PV cell 120. In one embodiment, one or more openings 165 are formed in metal substrate 161 that align with corresponding openings 155 in central portion 151 of lower cover 150 to facilitate the passage of current from PV cell 120, e.g., by way of conductors 122 and 124. In another embodiment, current is transmitted to and from PV cell 120 by way of lower cover 150 or primary mirror 130 in a manner similar to that disclosed in co-owned and co-pending U.S. Patent Application Serial Number 11/110,611 (cited above). Metal substrate 161 also defines one or more passages 169 that align with corresponding passages 159 defined in central portion 151 of lower cover 150 to facilitate the flow of optically transmissive material 128 out of cavity 113 during assembly. In one embodiment, the assembly including heat slug 160 and PV cell 120 is mounted onto central portion 151 of lower cover 150 prior to assembly onto optical element 110. In this embodiment, optically transmissive material 128 is inserted in a relatively liquid state into cavity 113 such that optically transmissive material 128 fills or nearly fills cavity 113, and then the assembly including lower cover 150, heat slug 160 and PV cell 120 is mounted such that PV cell 120 and heat slug 160 are inserted into cavity 113, thereby forcing excess optically transmissive material 128 through passages 159 and 169. Subsequent to this assembly process, a curing process is performed to convert optically transmissive material 128 from its relatively liquid state to a relatively solid cured state.

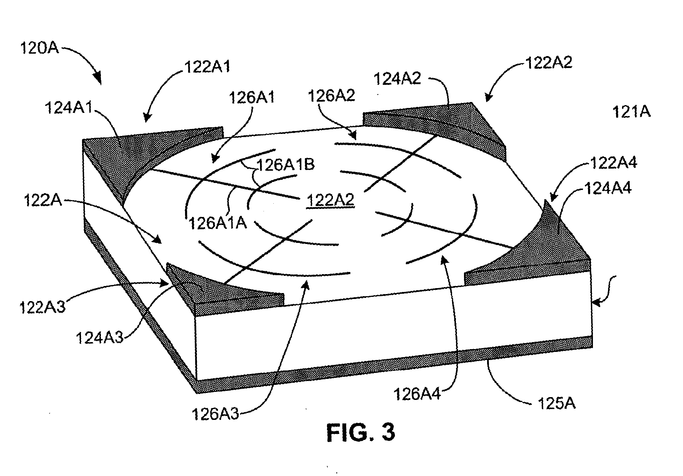

Fig. 3 is a top-side perspective view showing a PV cell 120A according to an alternative embodiment of the present invention. PV cell 120A includes a semiconductor (e.g., monocrystalline silicon) substrate 121A having a substantially square ("squarish") upper surface 122A including four corners 122A1 to 122A4. Metal electrical topside contact structures (pads) 124A1 to 124A4 are respectively disposed on substrate 121A in each of the four corners 122A1 to 122A4, and are arranged such that a substantially circular active area 122A2 of the upper surface is defined between metal electrical contact structures 124A1 to 124A4. Because the focused beam generated by a Cassegrain-type optical system is circular (e.g., see beams 55A and 55B, described with reference to Fig. 9), PV cell 120A facilitates efficient use of active area 122A2 by eliminating both the wasted light issue (e.g., see region 55A1 described with reference to Fig. 9) and the unused active area issue (e.g., see region 58A described with reference to Fig. 9), thus reducing production costs by minimizing the overall "chip" size of PV cell 120A. Contact structures 124A1 to 124A4A form an emitter terminal of PV cell 120A, and a base terminal of PV cell 120A is provided by a second electrical contact structure 125A disposed on the lower surface of substrate 121A. Contact structures 124A1 to 124A4A and 125A are formed using known techniques to facilitate connection to associated conductors formed on bottom cover 150 and/or heat slug 160 (both disclosed with reference to Figs. 1 and 2) by way of solder bumps (not shown), which are processed onto the wafer from which substrate 121A is diced prior to the dicing process. Suitable solder bump structures are well known in the art, and typically include an underbump metallization, a dielectric passivation, and a solder bump within an opening in the passivation.

In accordance with a further aspect of the present invention, PV cell 120A further includes metal gridlines 126A1 to 126A4 that extend in a radial and azimuthal pattern from contact structures 124A1 to 124A4, respectively. Because the light forms a circular spot centered on PV cell 120A, the photo-generated current will increase radially from center to the edges of the cell. As depicted in Fig. 3, each gridlines 126A1 to 126A4 includes a radial portion extending radially inward from contact structures 124A1 to 124A4, respectively, toward the center of PV cell 120A. For example, gridline 126A1 includes radial portion 126A1A extending from contact structure 124A1. These radial portions are optimally suited to the current generation of the cell. Optional azimuthal extensions (e.g., azimuthal extensions 126A1B) on the radial gridlines may be added to further reduce the distance carriers need to migrate within the semiconductor before reaching a gridline. Further optimization of the precise spacing and number of gridlines as well as their dimensions is dependent on the efficiency of PV cell 120A and the level of concentrated light reaching PV cell 120A, and is routinely undertaken by those skilled in the art of gridline optimization.

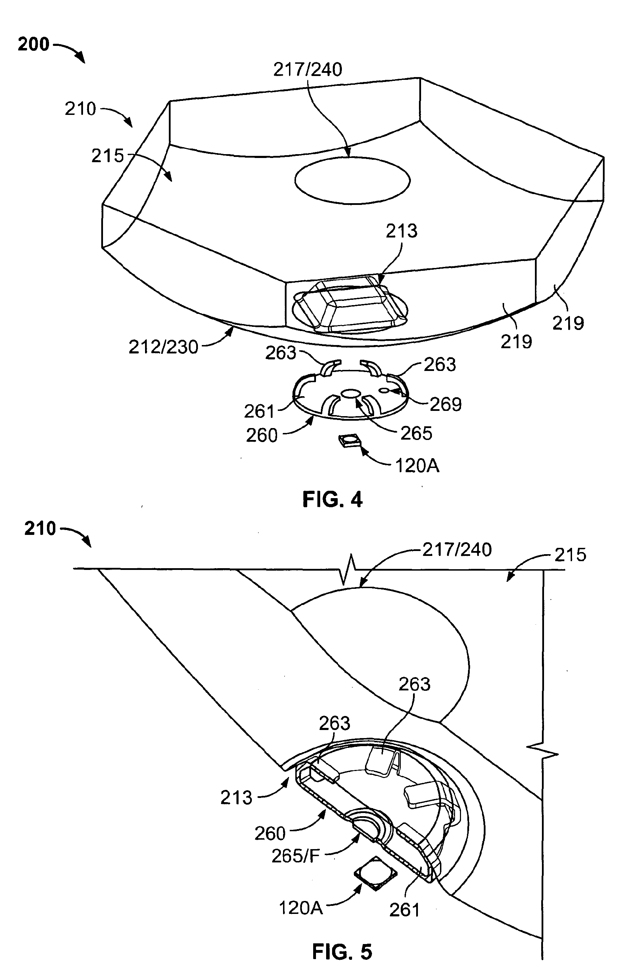

Figs. 4 and 5 are an exploded top-side perspective view and a partial cut-away perspective view showing a CPV device 200 according to another embodiment of the present invention. Similar to concentrating solar collector 100, concentrating solar collector 200 includes an optical element 210, PV cell 120A (described above), a primary mirror 230 formed on a convex surface 212 of optical element 210, a secondary mirror 240 formed on a concave surface 217 of optical element, and a heat slug 260. A lower cover (not shown) is mounted over convex surface 212 in a manner similar to that described above with reference to lower cover 160.

As indicated in Fig. 4, optical element 210 includes six contiguous facets 219 located around a peripheral edge of aperture surface 215. This six-sided arrangement facilitates the formation of large arrays of concentrating solar collectors 200 in a highly space-efficient manner, as discussed in additional detail in co-owned and co-pending U.S. Patent Application Serial Number 11/110,611 (cited above). In other embodiments, less space-efficient concentrating solar collector arrays may be produced using concentrators having other peripheral shapes (e.g., the circular peripheral shape of concentrator 100, described above). A central cavity 213 is defined in (e.g., molded into) convex surface 212 for receiving PV cell 120A.

In accordance with another aspect of the present invention, PV cell 120A is mounted onto a metal substrate 261 of heat slug 260, which is then mounted into cavity 213 of optical element 210. Given that optical element 210 is preferably made of glass, and heat slug 260 is preferably made of metal, it is expected that the two objects will have different coefficients of thermal expansion. Therefore, it is desirable for PV cell 120A and heat slug 260 form an assembly that self-centers itself into cavity 213. Accordingly, heat slug 260 includes a several resilient fingers 263 that have a fixed end integrally formed with or otherwise fixedly connected to metal substrate 261, and a curved body extending between its fixed and free ends. Resilient fingers 263 are shaped to facilitate self-alignment of the heat slug in cavity 213, thereby self-aligning PV cell 120A with the focal point F of the optical system formed by primary mirror 230 and secondary mirror 240 on optical element 210. For the purposes of this invention, the use of the term focal point refers both to concentration by imaging and non-imaging elements.

It is an aspect of this invention that the walls of cavity 213 are tapered. This tapering serves several useful functions. First, it accommodates the molding process. Second, in operation, should the assembled components within the expand due to thermal expansion, the tapered walls enable the components to accommodate the volume change by gliding out along the tapers.

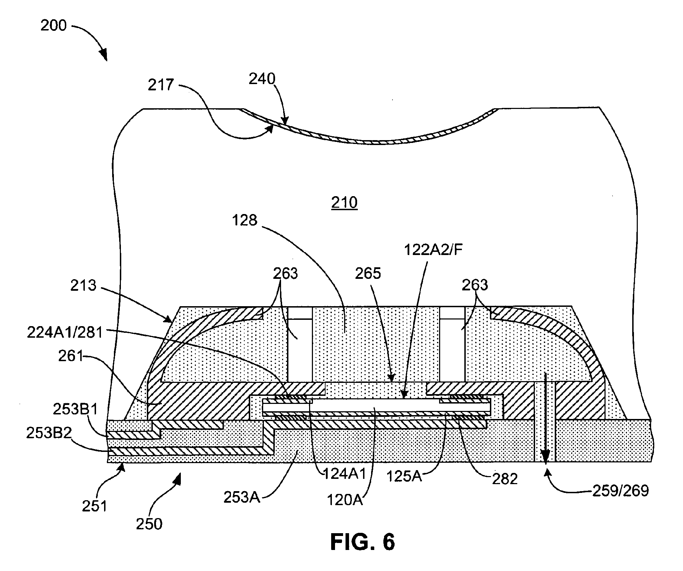

In one embodiment, which is depicted in Fig. 6, PV cell 120A is mounted onto the backside (lower) surface of heat slug 260, which defines a circular opening 265 that is positioned over the circular active area of PV cell 120A, and a lower cover 250 is mounted in the manner described above over the open end of cavity 213, thereby enclosing PV cell 120A and heat slug 260 therein. Lower cover 250 includes a flexible electrically non-conducting layer 253A and two or more conductors 253B1 and 253B2 that are disposed in non-conducting layer 253A. The emitter (topside) contacts of PV cell 120A (e.g., 224A1) are electrically connected to metal substrate 261 by way of solder bumps 281, which provides a conductive path between the emitter terminal of PV cell 120A and first external conductor 253B1 disposed in central portion 251 of a lower cover 250. Base (bottom side) contact structure 125A of PV cell 120A is electrically connected to second conductor 253B2 by way of solder bumps 282.

Although the present invention has been described with respect to certain specific embodiments, it will be clear to those skilled in the art that the inventive features of the present invention are applicable to other embodiments as well, all of which are intended to fall within the scope of the present invention. For example, the primary and secondary mirrors may be preformed and then mounted to the optical element using a suitable adhesive, but this approach may substantially increase production costs. In yet another alternative embodiment, the curved surface utilized to form the secondary mirror may be convex instead of concave, thus being in the form of a classical Gregorian type system. In yet another alternative embodiment, the curved surfaces utilized to form the primary and secondary mirrors may be elliptical, ellipsoidal, spherical, or other curved shape.

## Claims

1. A concentrating photovoltaic (CPV) device comprising:
a solid, light-transparent optical element having a convex surface defining a central cavity, and an opposing aperture surface and a curved surface defined in a central portion of the aperture surface;
a photovoltaic (PV) cell disposed in the central cavity; and
a resilient, optically transmissive material disposed in the central cavity between the PV cell and the optical element.

2. The CPV device according to Claim 1, wherein the optical element comprises glass.

3. The CPV device according to Claim 1 or 2, wherein the resilient, optically transmissive material comprises a gel material having a liquid uncured state and a solid cured state.

4. The CPV device according to one of the preceding Claims,
wherein the PV cell comprises means for converting light having a wavelength that is within a predetermined wavelength range into electricity, and
wherein the resilient, optically transmissive material is transmissive to light that is within said predetermined wavelength range.

5. The CPV device according to one of the preceding Claims, wherein the PV cell comprises a substrate having a squarish upper surface including four corners, and wherein a metal electrical contact structure is disposed in each of the four corners such that a substantially circular active area of the upper surface is defined between the metal electrical contact structures.

6. The CPV device according to Claim 5, further comprising a primary mirror disposed on the convex surface, and a secondary mirror disposed on the curved surface, wherein the primary and secondary mirrors are arranged such that light entering the optical element through the aperture surface is concentrated to form a circular beam that coincides with the circular active area of the PV cell.

7. The CPV device according to one of the preceding Claims, further comprising a lower cover including a central portion disposed over an open end of the central cavity of the optical element, and one or more peripheral portions extending from the central portion over the convex surface, wherein the PV cell is mounted on the central portion of the lower cover.

8. The CPV device according to Claim 7, wherein the lower cover comprises a laminate structure including one or more non-conductive layers and one or more metallization layers.

9. A method for producing a concentrating photovoltaic (CPV) device comprising:
forming a solid, light-transparent optical element having a convex surface defining a central cavity, and an opposing aperture surface and a curved surface defined in a central portion of the aperture surface;
mounting a photovoltaic (PV) cell onto a heat slug defining one or more passages;
disposing a optically transmissive material having a first, liquid state into the central cavity such that the optically transmissive material substantially fills the central cavity; and
mounting the heat slug inside the central cavity such that a portion of the optically transmissive material is extruded through the one or more passages.

10. The method of Claim 9, further comprising curing the optically transmissive material after mounting the heat slug such that the optically transmissive material assumes a second, solid cured state.
